# EUROPÄISCHE PATENTSCHRIFT

(11) **EP 2 430 418 B1**
(45) Veröffentlichungstag und Bekanntmachung des Hinweises auf die Patenterteilung: **10.07.2013**
(21) Anmeldenummer: 10725380.9
(22) Anmeldetag: 12.05.2010
(51) Int. Cl.: G01B 7/24, G01D 5/14, H01L 41/12, G01R 33/028, G01L 3/10

(54) **MESSVERFAHREN FÜR SENSORIK**
MEASUREMENT METHOD FOR SENSORS
PROCEDE DE MESURE POUR SYSTEME DE DETECTION

(30) Priorität: 12.05.2009 DE 102009020960; 26.05.2009 DE 102009022751
(43) Veröffentlichungstag der Anmeldung: 21.03.2012
(73) Patentinhaber: MTS Sensortechnologie GmbH Co. KG, 58513 Lüdenscheid (DE)
(72) Erfinder: KISKER, Erhard, 40627 Düsseldorf (DE)
(74) Vertreter: Pohlmann, Bernd Michael
(86) Internationale Anmeldenummer: PCT/EP2010/002892
(87) Internationale Veröffentlichungsnummer: WO 2010/130413

(56) Entgegenhaltungen:
- WO-A2-2007/051589

## Beschreibung

Die Erfindung betrifft ein Verfahren zum Messen mindestens einer der Größen Torsionswinkel, Längenänderung, Magnetfeld.

Es besteht großes Interesse daran, ein Magnetfeld, eine Torsion und/oder eine Längenänderung zu messen. Dies ermöglicht der in WO 2007/051589 A2 beschriebene Sensor. Allerdings bewirken alle drei Größen ähnlich starke Änderungen des Sensorsignals, so dass die nicht zu messenden Größen möglichst fixiert werden sollten oder Referenzsensoren zur Ermittlung der nicht zu messenden Größen und zur Korrektur des Signals einzusetzen sind. Eine gemeinsame Bestimmung der Torsions- und der Dehnungsspannung bzw. deren Änderungen bei Benutzung eines bezüglich keiner der erwähnten Größen fixierten Sensors ist bislang nicht möglich.

Aufgabe der Erfindung ist es, die Messung einer oder mehrerer der Größen Umgebungsmagnetfeld, Längsdehnung und Torsionswinkel, auf die der Sensor primär empfindlich ist, weniger anfällig gegen Störungen, insbesondere durch Änderungen der anderen Größen zu machen.

Diese Aufgabe wird gelöst mit einem Verfahren gemäß dem Anspruch 1. Die Unteransprüche beinhalten besonders günstige Ausführungen des erfindungsgemäßen Verfahrens.

Zum Messen mindestens einer der Größen Torsionswinkel, Längenänderung, Magnetfeld mittels eines Sensors wird erfindungsgemäß in einem ersten Leiterabschnitt einer magnetisierbaren oder magnetisierten elektrisch leitenden Leiteranordnung eine dynamische, insbesondere helikale Magnetisierung erzeugt. Dies erfolgt beispielsweise durch Anlegen eines Magnetfelds an den Leiterabschnitt mit einem zu diesem parallelen Vektor, vorzugsweise verläuft das Magnetfeld insgesamt möglichst parallel zu dem Leiterabschnitt, und Bestromen des Leiterabschnitts mit einem Stromimpuls. Hierdurch entsteht eine Magnetisierung, die von dem ersten Leiterabschnitt in einen zweiten Leiterabschnitt wandert, der eine insbesondere helikale Anisotropie aufweist. Die Anisotropie (z.B. ein gedrehter Leiter oder ein gewellter Leiter) ermöglicht ein Erfassen der so transportierte Magnetisierung mittels einer über dem zweiten Leiterabschnitt auf Grund des Transportes der Magnetisierung erzeugten Spannung, die ein Maß für die Größe des Torsionswinkels, der Längenänderung, des Magnetfeldes oder ein Mischmaß mehrerer dieser Größen ist.

Während der Messung wird zumindest ein Leiterabschnitt der Leiteranordnung, insbesondere die gesamte Leiteranordnung einem in seiner Magnetfeldstärke veränderten Magnetfeld ausgesetzt und die dynamische, insbesondere helikale Magnetisierung wird bei mindestens zwei unterschiedlichen Magnetfeldstärken des veränderbaren Magnetfelds ermittelt. Die so erhaltenen mindestens zwei bei den unterschiedlichen Magnetfeldstärken erzeugten und detektierten Spannungen werden gemeinsam zur Bildung des Maßes für die Größe des Torsionswinkels, der Längenänderung und/oder des Magnetfeldes verwendet werden.

Die Erfindung ermöglicht es, auch die Änderung aller drei Größen quasi-gleichzeitig zu messen. Beides wird durch Ausnutzung der charakteristischen Magnetfeldabhängigkeit des Sensorsignals vom Zustand jeder der beiden mechanischen Größen erreicht. Das Verfahren wird hier beispielhaft für den nachfolgend beschriebenen Sensor erläutert, ist in wesentlichen Teilen aber auch auf andere Sensoren anwendbar, die auf Magnetoelastizität beruhen.

Die Vorteile des Verfahrens liegen darin, einerseits die sehr große Empfindlichkeit des Sensors bezüglich Änderungen des Umgebungsmagnetfeldes, der Torsions- und der Zugspannung für präzise Messungen z.B. einer dieser Größen nutzen zu können, indem verfahrensgemäß die Empfindlichkeit für diejenigen Größen, die im Einzelfall nicht von Interesse sind, vermindert oder weitgehend eliminiert wird. Ferner ermöglicht das Verfahren den Verzicht auf eine magnetische Abschirmung, wenn eine oder beide mechanischen Größen gemessen werden sollen. Alternativ kann die Anforderung an den Abschirmfaktor einer Magnetfeldabschirmung reduziert werden, was deren Kosten und Gewicht vermindert. Ferner ist es möglich, die drei genannten Größen praktisch gleichzeitig mit nur einem Sensor zu messen. Dies ist kostengünstig und platzsparend.

Die Erfindung wird nachfolgend an Hand von Figuren näher beschrieben.

Es zeigen
Fig. 1: Die Sensoranordnung, bestehend aus dem schraffiert gezeichneten Sensormaterial (3), den elektrischen Kontakten A,B,C,D und einer um das zwischen A und B liegende Segment des Sensors angebrachten Spule (4) (oberes Bild) oder einer den ganzen Sensor umgebenden Spule (unteres Bild) zur Erzeugung des Kontrollmagnetfeldes Hₖ. Bei Torsionsmessungen wird mindestens das zwischen C,D liegende Segment des Sensors verdrillt. Strompulse (8) werden in die Kontakte A,B eingespeist, woraufhin bipolare Signalimpulse (9) in der Nähe der Flanken des Stromimpulses erscheinen.
Fig. 2: S(Hₖ)-Abhängigkeit (1) mit eingezeichneten Änderungen der Positionen der dominierenden Peaks bei Änderung eines äußeren Magnetfeldes um ΔH, des Torsionswinkels und der Zugspannung um ΔZ. Das Kontrollmagnetfeld wird zwischen Hₘᵢₙ und Hₘₐₓ durchgefahren. Das Sensorsignal wurde gleichgerichtet. Die Phase des Signals ist rechts und links von Hₖ=0 entgegengesetzt.
Fig. 3: Zusammensetzung des auf das Sensormaterial wirkenden Magnetfeldes H aus den Komponenten des Kontrollmagnetfeldes Hₖ und des Umgebungsmagnetfeldes Hᵤ.
Fig. 4: Gleichgerichtete S(Hₖ)-Abhängigkeiten für zwei verschiedene Zugspannungen sowie die ersten Ableitungen. Der Sensor hat eine H₁ bzw. H₂ entsprechende transversale Anisotropie und eine negative Magnetostriktionskonstante.
Fig. 5: Die Peakseparationsänderung (H'₁-H'₂)- (H₁-H₂) bei Längsdehnung eines 30x1.2x0.02mm Sensorstreifens mit transversaler magnetischer Anisotropie und negativer Magnetostriktionskonstanten.
Fig. 6 Gleichgerichtete S(Hₖ)-Abhängigkeiten für verschiedene Torsionswinkel, wobei der Winkel sich von positiv (Kurve 40) zu negativ ändert (Kurve 42).
Fig. 7: Zeitlicher Verlauf der Impulse an den Kontakten C,D (9) als Antwort auf den Strompuls (8). Der Torsionswinkel wurde variiert.
Fig. 8: S(Hₖ)-Abhängigkeiten aus der Integration über die ersten 30ns nach der steilen Flanke des Strompulses des zeitaufgelösten Sensorsignals. Die Parameter der Kurven umfassen z.B. eine Torsionsänderung, die wie in der Fig. 9 gezeigt bei dem später erscheinenden Teil des Impulses bis zu einem Vorzeichenwechsel der Kurve führen, sowie Zugspannungänderungen.
Fig. 9: S(Hₖ)-Abhängigkeiten aus der Integration des 100ns nach der einer steilen Flanke des Strompulses erscheinenden zeitaufgelösten Sensorsignals. Die Kurven (20) und (21) unterscheiden sich durch das Vorzeichen des Torsionswinkels und gehen stetig bei dessen Änderung auseinander hervor. Bei Torsionswinkel 0 ist die Kurve praktisch konstant Null (bis auf einen kleinen teilweise elektronisch bedingten Untergrund).
Fig. 10: Zeitabhängigkeiten des an den Kontakten C,D auftreten Sensorimpulses (12), (13) als Antwort auf die in A,B eingespeisten Stromimpulse (10) und (11), die unterschiedliche Anstiegszeit haben. (14) Kennzeichnet einen dominierenden Peak, der bei der längeren Anstiegszeit des Anregungsimpulses erhalten wird.
Fig. 11: Abhängigkeit des zeitaufgelösten Sensorsignals bei flacher Strompulsflanke (11) in Fig. 10 für festes Kontrollmagnetfeld und Änderung des Torsionswinkels ((14),(15)) sowie Erhöhung der Zugspannung ((15),(16)).
Fig. 12: Mittels LC-Resonanzkreis verstärktes Sensorsignal bei optimierter flacher Flanke des Stromimpulses, als Funktion des Torsionswinkels, bei optimalem Magnetfeld gemessen. Ein elektronischer Untergrund wurde nicht abgezogen. Torsionswinkel 0 entspricht dem planen Sensor. Das Sensormaterial war ein Streifen aus Vitrovac 6025F mit leichter Magnetisierungsrichtung senkrecht zur Längsrichtung des Sensors (Fig. 1).

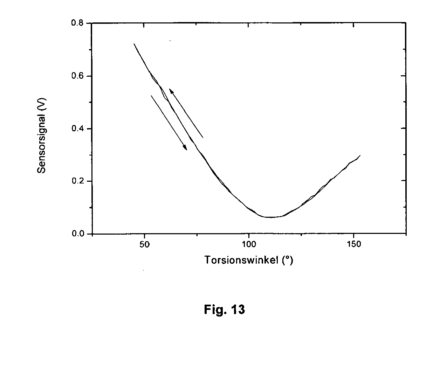

Fig. 13: Hysteresekurve des Sensorsignals für Vitrovac 6025F als Funktion des Torsionswinkels im Bereich des Minimums (90) der Fig. 12 (jedoch andere Messung)

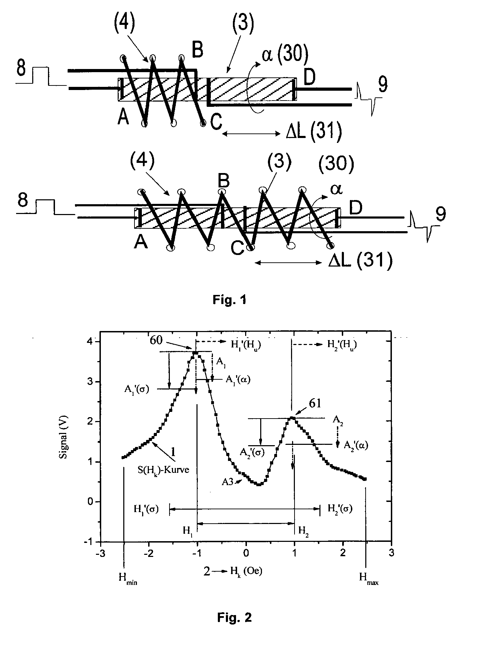

Die Sensoranordnung WO 2007/051589 A2 benutzt vorzugsweise weichmagnetische amorphe oder nanokristalline Legierungen, deren Auswahl sich nach den Messkriterien richtet. Sollen auch Zugspannungen gemessen werden, wird als Sensormaterial vorzugsweise eine Legierung benutzt, die eine negative Magnetostriktionskonstante sowie eine leichte Magnetisierungsrichtung quer zur Längsachse des Sensors besitzt. Beispiele sind die im Quermagnetfeld getemperten Legierungen Vitrovac 6025, 6030 oder 6155. Der Sensor besteht aus einem schmalen Streifen (der auch ein Draht sein kann) dieser Materialien mit einer herstellungsbedingten Dicke von ca. 20µm, der wie in WO 2007/051589 A2 beschrieben mit vier Kontakten A,B,C,D versehen wird (Fig. 1), wobei in die Kontakte A,B uni- oder bipolare Strompulse (8), vorzugsweise unipolare, eingespeist werden. Als Antwort auf die Flanken der Strompulse erscheinen in jedem Fall bipolare Signalpulse, die das primäre Sensorsignal (9) darstellen und deren Amplitude, Phase und Zeitverhalten in vielfältiger Weise von den Größen Umgebungsmagnetfeld, Längsdehnung und Torsionswinkel abhängt. Im einfachsten Falle wird das primäre Sensorsignal unspezifisch verstärkt und gleichgerichtet, wobei auch die direkte Phaseninformation (Vorzeichen der Signalimpulse) verloren geht. Während das phasenempfindlich gemessene Sensorsignal bei einem Torsionswinkel Null für jedes Magnetfeld und Längsdehnung praktisch verschwindet und nach dem Nulldurchgang mit entgegengesetzter Phase wieder erscheint, zeigt das gleichgerichtete Signal als Zeichen für den Nulldurchgang ein Minimum. Die Figur 2 zeigt eine so gemessene Abhängigkeit des Sensorsignals (S) von einem Kontrollmagnetfeld (Hₖ) (2), das dem Sensor überlagert ist (S(Hₖ)-Abhängigkeit) (1) für ein Material der nominellen Zusammensetzung Co₇₀/Si+B₂₃/Mn₅/Fe+Mo₂ für einen Torsionswinkel von 45°. Sie besitzt eine typische Doppelpeak-Struktur, wobei beide Peaks, A₁ (60) und A₂ (61), sehr unterschiedliche Höhen besitzen können, jedoch symmetrisch zu Hₖ=0 liegen, sofern kein weiteres Magnetfeld vorhanden ist. Schon die so mit einfachster Elektronik gemessene Kurve beinhaltet umfangreiche Information über den Zustand des Sensors bezüglich des magnetomechanischen Zustandes, während die Analyse des Zeitverhaltens der Signalimpulse (9) weitere Informationen enthält, die ebenfalls, allerdings mit komplexerer Elektronik, ausgewertet werden kann. Die zu den Peaks A₁ (60) und A₂ (61) gehörigen Magnetfeldwerte H₁ und H₂ auf der Hₖ-Achse entsprechen im entspannten Zustand des Sensors (ΔL =0, (31)) in guter Näherung dem magnetischen Anisotropiefeld des Materials, so dass durch Wahl des Sensormaterials eine Anpassung an spezielle Erfordernisse möglich ist. Typische Werte von H₁ sind 1-10 Oe (Oerstedt). Der prinzipielle Verlauf der Kurve ist für alle untersuchten Materialien ähnlich, die Peaks können jedoch auf eine einzige Struktur in der Umgebung von Hₖ=0 verschmolzen sein, insbesondere bei "as cast" Materialien. Die Zugspannung σ ist mit der Längenänderung ΔL (31) über das Elastizitätsgesetz verknüpft, so dass diese daraus bestimmt werden kann. Das Kontrollmagnetfeld (Hₖ) (2) kann mittels einer Spule (4) erzeugt werden (Fig. 1), die nur den Teil AB des Sensors (3) oder den gesamten Sensor umschließt. Die S(Hₖ)-Abhängigkeit unterscheidet sich in den beiden Fällen, was jedoch für das Funktionieren des Verfahrens nicht erheblich ist. Die größte Genauigkeit wird jedoch erreicht, wenn die Spule den gesamten Sensor umgibt. Ebenfalls kann sich die Torsion auf den gesamten Sensor oder nur den zwischen C,D gelegenen Teil erstrecken, was ebenfalls zu unterschiedlichen S(Hₖ)-Abhängigkeiten und unterschiedlicher Abhängigkeit der Form der Kurven von der Torsion führen kann.

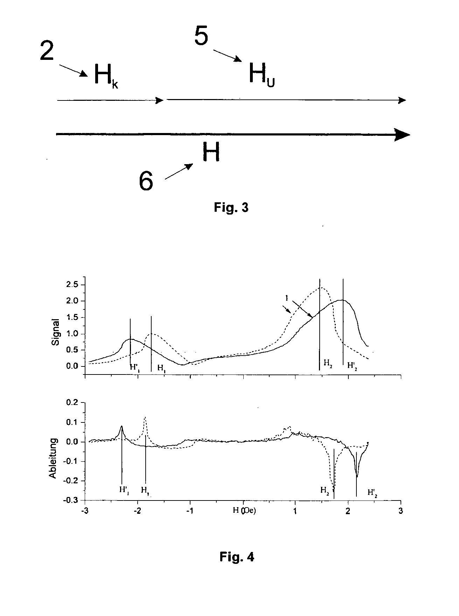

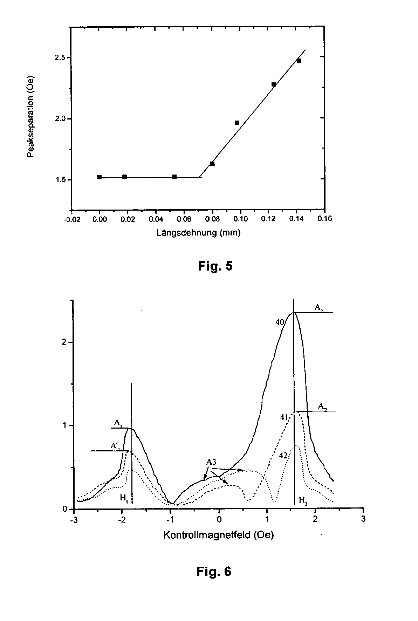

Für ein vorgegebenes Material ändert sich die S(Hₖ)-Abhängigkeit in charakteristisch unterschiedlicher Weise bei Änderungen der Größen Umgebungsmagnetfeld (Hᵤ) (5), Torsionswinkel α (30) und Zugspannung σ bzw. Längenänderung ΔL (31). Die Änderung einer der drei Größen Umgebungsmagnetfeld (Hᵤ) (5), Torsionswinkel α (30) und Länge ΔL(31) bei Fixierung der beiden anderen bewirkt folgende Änderungen der S(Hₖ)-Abhängigkeit (1) (siehe auch Fig. 2):
a) Änderung des Umgebungsmagnetfeld (Hᵤ) (5): kongruente Verschiebung der S(Hₖ)-Abhängigkeit (1), unveränderte Kurvenform
   Für die Magnetisierung des Sensormaterials ist das aus (Hₖ) (2) und Hᵤ (5) resultierende Gesamtfeld H (6) maßgebend (s. Fig.3). Ändert sich Hᵤ (5) um ΔH, so verschiebt sich die S(Hₖ)-Abhängigkeit kongruent um -ΔH. Die dominierenden Peaks liegen in der S(Hₖ)-Abhängigkeit bei H₁'(Hᵤ)=H₁-ΔH und H₂'(Hᵤ)=H₂-ΔH, d.h. der Peakabstand bleibt unverändert. Das Umgebungsmagnetfeld Hᵤ = ΔH ergibt sich zu ΔH= ½(H₁'+ H₂'), da H₂=-H₁.
b) Änderung des Torsionswinkel: Die Amplituden A₁ (60), A₂ (61) der beiden charakteristischen Peaks ändern sich im allgemeinen um ungleiche Beträge zu A'₁(α) und A'₂(α), während H₁ und H₂ in guter Näherung unverändert bleiben (Fig. 6). Die Kurvenform ändert sich ebenfalls deutlich.
c) Längenänderung um ΔL (31): Es ändern sich die Peakpositionen auf der Hₖ-Achse von H₁,H₂ zu H₁'(σ),H₂'(σ). Dies erfolgt in guter Näherung symmetrisch zu Hₖ=0 (Fig. 4). Ferner ändern sich die Peakamplituden von A₁, A₂ zu A'₁(σ),A'₂(σ). Aus der Differenz der Peakabstände σHₖ(σ)= |H₁'(σ)-H₂'(σ)| - |H₁-H₂| vor und nach einer Änderung der Zugspannung folgt für deren Änderung Δσ=k(σ)* |H₁'(σ)-H₂'(σ)| - |H₁-H₂|. Der Parameter k(σ) ist bei nicht zu großer Zugspannung unabhängig von σ. Die Zugspannung σ entsteht bei Dehnung oder Stauchung des Sensormaterials bezüglich seiner Länge L₀ im entspannten Zustand und hängt im elastischen Bereich gemäß der Beziehung σ=E*ΔL/L₀ von der Längenänderung ΔL ab, wobei E der Elastizitätsmodul ist. Die Längsdehnung (31) ergibt sich zu ΔL= k'(ΔL)* |H₁'(σ)-H₂'(σ)| - |H₁-H₂| mit entsprechendem Parameter k'(ΔL). Eine Kalibrierung von k bzw. k' anhand von Messdaten für bekannte Dehnungen kann für genaue Messungen notwendig sein. Figur 5 zeigt die Änderung der Peakseparation bei einer bei ca. 0.07 mm einsetzenden Längsdehnung, ausgehend vom entspannten Zustand. Die Abstandsänderung der Peaks korreliert mit der Magnetostriktionskonstanten des Materials, so dass sogar gemäß des bekannten Zusammenhangs zwischen der Zugspannung, der Magnetostriktionskonstanten des Sensormaterials und dessen Anisotropiefeldstärke quer zur Längsrichtung US 7,375,513 B2 die Längenänderung absolut bestimmt werden kann.

Bei Materialien mit verschwindend kleinen Magnetostriktionskonstanten ist die Änderung der Peakseparation bei Längenänderung ebenfalls verschwindend klein, die Streckung des Sensors äußert sich dennoch in einer Abnahme der Peakamplituden.

Die S(Hₖ)-Abhängigkeit als Ganzes, insbesondere bei Benutzung von Materialien mit nicht verschwindender Magnetostriktionskonstante, kann daher zur Bestimmung des Magnetisierungs-, Torsions- und Dehnungszustandes des Sensors genutzt werden. Es reicht jedoch für den Fall der mechanischen Fixierung eines der beiden mechanischen Freiheitsgrade aus, nur wenige charakteristische Merkmale der S(Hₖ)-Abhängigkeit (1) zu nutzen. Als solche können die Magnetfeldwerte H, und H₂, bei denen die beiden dominierenden Peaks auf der Hₖ -Achse liegen, sowie deren Amplituden A₁ und A₂ dienen. Die beschriebenen Änderungen dieser beiden charakteristischen Merkmale der S(Hₖ)-Abhängigkeit (1) erlauben die Separation des Magnetfeldeinflusses von dem Einfluss des Torsionswinkels oder der Zugspannung. Da eine Amplitudenänderung sowohl bei Zugspannungsänderung als auch bei Torsion auftritt, während der Peakabstand auf der Hₖ-Achse in guter Näherung unabhängig von der Torsion ist, kann eine Torsionswinkeländerung nur dann nur aus den Amplituden A₁ (60) und/oder A₂ (61) bestimmt werden, wenn der Sensor bezüglich der Längsdehnung fixierten ist. Eine gleichzeitig erfolgende Längenänderung kann in gewissen Grenzen durch eine tabellarische Ermittlung der Amplituden A₁ (60) und/oder A₂ (61) als Funktion der Längsdehnung korrigierend rechnerisch berücksichtigt werden. Umgekehrt ist eine präzise Fixierung des axialen Torsionsfreiheitsgrades für Zugspannungsmessung nicht unbedingt notwendig. Der Torsionswinkel muss jedoch ≠0 sein, da sonst das Sensorsignal im Wesentlichen ebenfalls Null ist, unabhängig vom Magnetfeld und der Zugspannung, und sollte ungefähr auf den für die maximale Signalhöhe notwendigen Wert festgelegt werden. Der optimale Torsionswinkel hängt vom Sensormaterial ab. Auf eine solche Vortorsion kann verzichtet werden, wenn dem Sensormaterial durch anderweitige Behandlung (z.B. durch Stromtempern in angelegtem Magnetfeld) eine helikale Anisotropie eingeprägt worden ist. In diesem Falle kann der Sensor planar bleiben, was für die Herstellung vorteilhaft ist.

Ein Messverfahren zur gleichzeitigen Bestimmung des Umgebungsmagnetfeldes Hᵤ, der Zugspannung σ bzw. der Längsdehnung ΔL und des Torsionswinkels α kann folgendermaßen durchgeführt werden: Die S(Hₖ)-Abhängigkeit (1) bzw. eine ihrer Ableitungen wird repetierend und schneller gemessen, als sich die Größen Hᵤ, ΔL, α ändern. Dies kann mit Hilfe von Signalprozessoren und programmierbarer Logik (FPGA) sehr schnell erfolgen, begrenzt durch Induktivität und Widerstand der Spule (4) einschließlich der Zuleitungen. Die Kurve wird ständig hinsichtlich der Peakpositionen H₁ und H₂ sowie für Torsionsmessungen bezüglich deren Amplituden A₁ und A₂ ausgewertet und daraus wie oben beschrieben die zu messenden Größen bestimmt. Da die Form der S(Hₖ)-Abhängigkeit für jede Torsion und jede Zugspannung unterschiedlich ist (vgl. Fig. 4 und 6), lässt sich durch Vergleich weiterer diskreter charakteristischer Merkmale (z.B. eines in der Nähe von Hₖ=0 bei Torsion auftretenden Peaks A₃ (Fig. 4 und 6) in der gleichgerichteten S(Hₖ)-Abhängigkeit (was einem Minimum in der phasenrichtig dargestellten Kurve entsprechen kann) oder schließlich der gesamten S(Hₖ)-Abhängigkeit mit Referenzwerten bzw. Referenzkurven der magnetomechanische Zustand des Sensors, allerdings unter dem Einfluss der wechselnden Magnetisierung infolge der Strompulse bestimmen. Eine magnetische Abschirmung ist also für Torsions- und Längenänderungsmessungen nicht notwendig, mag jedoch zur Verbesserung der Meßgenauigkeit oder zur Einschränkung des zu variierenden Bereichs der Kontrollmagnetfeldstärke hinzugefügt werden.

Das beschriebene Verfahren beruht darauf, das Kontrollmagnetfeld zwischen einem genügend großen negativen Wert und einem genügend großen positiven Wert zu variieren, um sowohl den linken (60) als auch den rechten dominierenden Peak (61) der S(H_{K})-Abhängigkeit (1) unter dem Einfluss eines Umgebungsmagnetfeldes Hᵤ zu erfassen. Dies erfordert eine gewisse Energie. Es besteht jedoch die Möglichkeit, den Energiebedarf zu reduzieren. Das kann durch Benutzung zweier Sensoren aus Materialien mit unterschiedlichen Magnetostriktionskonstanten und/oder Anisotropiefeldstärken erreicht werden. Anstelle des linken und des rechten Peaks eines einzigen Materials auf der Hₖ-Achse können dann die auf einer Seite der Hₖ-Achse liegenden Peaks beider Materialien zur Bestimmung der drei Größen Hᵤ, σ, α benutzt werden. Die Hₖ-Werte der beiden Peaks sind *H*₁ = *H*_{1.0} + αΔ*L* + Δ*Hᵤ* und H₂ *= H*_{0,2} + *b*Δ*L* + Δ*Hᵤ* wobei H_{1,0} und H_{2,0} die durch die jeweiligen Quer-Anisotropiefelder bestimmten Hₖ-Werte beider Materialien im entspannten Zustand bzw. einem Referenz-Ausgangszustand und a,b die Proportionalitätskonstanten zwischen der Längsdehnung und der Verschiebung der dominierenden Peaks auf der Hₖ-Achse bei Änderung der Zugspannung sind. Da a,b als Materialeigenschaft bekannt sind bzw. bestimmt werden können, lassen sich die beiden Unbekannten ΔL und ΔHᵤ in den beiden obigen Gleichungen bestimmen. So braucht H_{K} dann nur im Bereich der beiden Peaks für ein bestimmtes Vorzeichen des Kontrollmagnetfeldes variiert zu werden, unter Berücksichtigung des zugelassenen Bereichs der Umgebungsmagnetfeldänderung. Mittels eines Permanentmagneten kann ein Grundmagnetfeld in der Nähe der beiden H₁-Werte vorgegeben werden, so dass das Kontrollmagnetfeld nur in einem relativ kleinen Bereich variiert werden muss. So kann der Energieaufwand verringert und die maximale Messgeschwindigkeit erhöht werden. Als Permanentmagnet zur Einstellung eines Grundmagnetfeldes hat sich ein dünner magnetisierter Draht von 15 mm Länge bewährt, der an einer für das Sensorsignal optimalen Stelle angebracht wird. Es wurde beobachtet, dass dadurch sowohl eine hohe Empfindlichkeit des Sensorsignals bezüglich Torsionsänderungen erzielt wird als auch eine starke Verminderung des Einflusses des Umgebungsmagnetfeldes.

Neben der generellen Möglichkeit der Bestimmung der Größen Hᵤ, α, ΔL mittels der repetierten Auswertung der Signal(Kontrollmagnetfeld)-Abhängigkeit bietet die Kenntnis der Hₖ-Abhängigkeit des aktuellen Sensors die Möglichkeit der Optimierung einfacherer Messverfahren zur Bestimmung einer oder mehrerer der Größen Hᵤ, α, ΔL, indem nur das Sensorsignal bei festem Wert des Kontrollmagnetfeldes, ohne die Ermittlung der S(Hₖ)-Abhängigkeit (1) gemessen wird. Für Torsionsmessungen kann dazu die Höhe eines oder beider Peaks (60) oder (61) gemessen werden, auf die das Hₖ-Feld fest eingestellt wird. Wird Hₖ auf einen Wert für das Maximum eines dieser Peaks eingestellt, wirken sich kleinere Variationen der Peaklage auf der Hₖ-Achse infolge von Umgebungsmagnetfeldänderungen oder Zugspannungsänderungen auf die Signalhöhe nicht oder nur geringfügig aus, da die Steigung der S(Hk)-Abhängigkeit dort Null ist. Bei zu erwartenden größeren Änderungen dieser Parameter kann Hₖ dynamisch bezüglich Änderungen des Umgebungsmagnetfeldes oder der Zugspannung korrigiert werden.

Die Längenänderung wird im einfachsten Fall durch Messung der Signalamplitude bei Einstellung von Hₖ mittels einer stromdurchflossenen Spule (4) oder eines Permanentmagneten auf einen Wert ungleich H₁ oder H₂ bestimmt. Die Empfindlichkeit ist am größten in der Nähe des größten Gradienten der Signal(Kontrollmagnetfeld)-Abhängigkeit. Eine Peakverschiebung infolge einer Änderung des Umgebungsmagnetfeldes kann durch Messung desselben z.B. mit demselben Sensor und Nachführung des Kontrollmagnetfeldes korrigiert werden. In gewissem Umfang kann auf die dynamische Nachführung des Kontrollmagnetfeldes verzichtet werden, indem die Verschiebung der S(Hₖ)-Abhängigkeit (1) rechnerisch berücksichtigt wird.

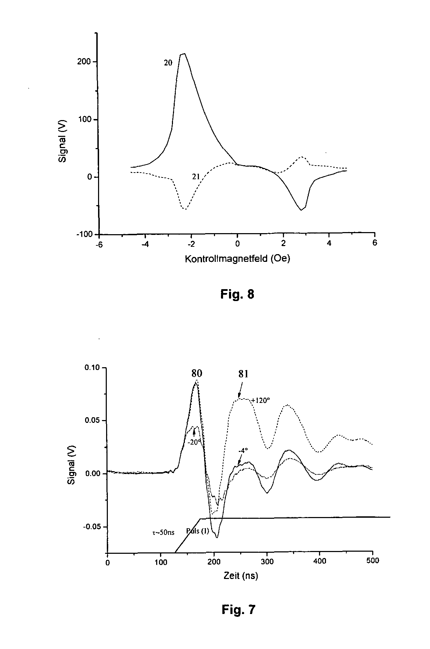

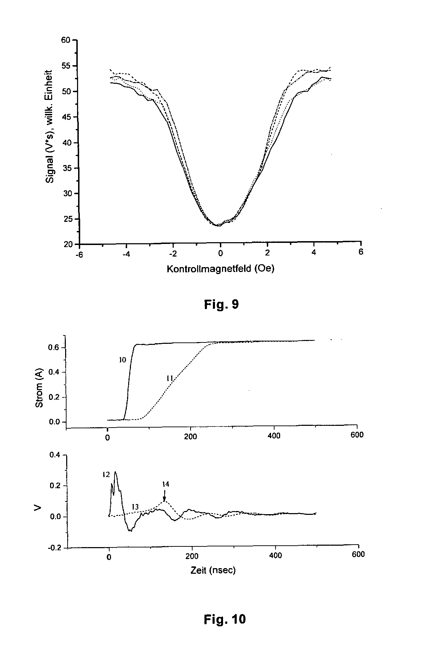

Auch der zeitliche Verlauf des einzelnen Sensorsignalimpulses (9) als Antwort auf den Anregungsstromimpuls (8) hängt vom Zustand des Sensormaterials hinsichtlich Hᵤ, α, ΔL ab. Der Signalimpuls (9) enthält viele Oberwellen, deren einzelne Abhängigkeiten vom Sensorzustand unterschiedlich sind und ebenfalls ausgewertet werden können. Dies trifft auch für zeitaufgelöste Komponenten des Sensorimpulses zu. Die zeitliche Struktur des Sensorsignalimpulses ist von Oszillationen mit unterschiedlichen Frequenzen geprägt. Sie hängt in sehr komplexer Weise von den Größen Hᵤ, α, ΔL ab. Die Figur 7 zeigt dies exemplarisch für zwei Komponenten des Signals zu verschiedenen Zeiten, bezogen auf die Flanke des Stromimpulses, bei festem Hₖ (dieses auf maximales Signal eingestellt) und das Material VC 6025F. Die Anstiegszeit des Stromimpulses betrug 50ns. Die zeitlich zuerst erscheinende Komponente (80) ändert sich im negativen Torsionsbereich (bezogen auf die planare Ausrichtung, α=0) bei Torsion von α=-20° auf -4° sehr stark, während die späteren Signaloszillationen (81) sich dabei nur wenig ändern. Andererseits ändert sich im positiven Torsionsbereich (α>0) die erste Komponente (80) nur noch geringfügig, während die späteren Komponenten (81) sich hier sehr stark ändern und erst bei α∼90° ein Maximum erreichen. Auch die Magnetfeldabhängigkeit der zeitlich aufgelösten Signalimpulskomponenten ist sehr unterschiedlich. Dies zeigen die Figur 8 und Figur 9. In Figur 8 wurde das zeitaufgelöste Sensorsignal über die ersten 30ns nach der Flanke des Stromimpulses integriert und als Funktion von Hₖ, der Torsion und der Zugspannung gemessen. Die Magnetfeldabhängigkeit ist sehr stark, diejenige auf die mechanischen Änderungen dagegen nur gering. In Figur 9 wurde das später, mehr als 100 ns nach der Flanke des Stromimpulses erscheinende Sensorsignales gemessen. Dies zeigt eine sehr starke Magnetfeld,- Torsionswinkel und Zugspannungsabhängigkeit. Die zeitliche Struktur des Sensorsignals kann für bestimmte Messaufgaben gezielt ausgenutzt werden, indem mittels eines Signalprozessors bestimmte zeitliche Komponenten des Signalimpulses getrennt ausgewertet werden.

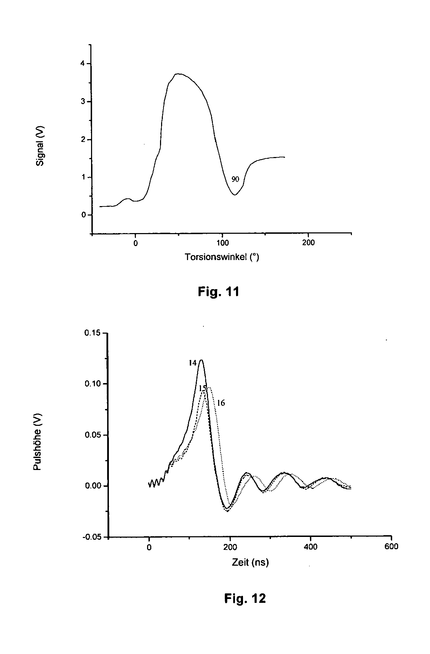

Eine weitere wichtige Größe ist die Anstiegszeit (für die Abfallzeit gilt ähnliches) der anregenden Stromimpulse (8). Ist diese klein (<ca. 30 ns) so treten starke Oszillationen des Signalimpulses (9) auf, dessen einzelne zeitlich ausgewählte Komponenten wie zuvor beispielhaft beschrieben unterschiedliche Empfindlichkeiten bezüglich der Größen Hᵤ, α, σ haben. Wie beschrieben wird die maximale Torsionsempfindlichkeit in diesem Beispiel ca. 100ns nach der Flanke der in A,B eingespeisten Anregungspulse erreicht (Fig. 7). Messtechnisch einfacher als die zeitliche Struktur des Signalimpulses auszuwerten ist es, die schnellen Signalkomponenten (80) von vornherein durch eine geeignet eingestellte längere Anstiegszeit der Stromimpulse zu unterdrücken. Die Figur 10 zeigt in den Kurven (12) und (13) das Ergebnis. Bei genügend flacher Flanke (11) werden die schnell erscheinenden Oszillationen unterdrückt und anstelle vieler Oszillationen im gesamten Verlauf des Signalimpulses wird im wesentlichen ein breiter Impuls (14) erzielt, der anschließend mit relativ geringer Verstärkungsbandbreite verarbeitet werden kann. Die Figur 12 zeigt die Abhängigkeit des zeitlichen Verlaufs des Signalimpulses bei flacher Stromimpulsflanke für Änderungen der Zugspannung und der Torsion bei festem Kontrollmagnetfeld (ca. 1 Oe). Bei Torsion ändert sich die Peakhöhe, bei Zugspannung die Position auf der Hₖ-Achse. Durch geeignete Wahl der Anstiegszeit des Stromimpulses lässt sich auch erreichen, dass sich die Lage des Peaks auf der Zeitachse bei Torsionsänderung verschiebt. Die Signalimpulse, die bei der abfallenden Flanke des Stromimpulses auftreten, zeigen ähnliche Charakteristika wie die oben für die ansteigende Flanke beschriebenen.

Die mit der Abflachung der Pulsflanken einhergehende Reduzierung von schnellen Oszillationen des Signalimpulses auch im zeitlich von den Flanken weiter entfernten Bereich liegt möglicherweise daran, dass bestimmte Anregungen des Spinsystems nur bei schnellen Flanken erzeugt werden, eventuell im Sinne der Voraussage von L. Berger: L. Berger, J. Appl. Phys. 71, 2721 (1992).

Die unmittelbar nach schnellen Impulsflanken erscheinenden Oszillationen (12), Figur 10, lassen sich selektieren indem die Stromimpulse kurz genug gemacht werden. Dies geht naturgemäß mit einer Reduzierung des Leistungsbedarfs für den Betrieb des Sensors einher.

Eine sehr einfache experimentelle Methode zur Messung von Hᵤ, α, ΔL ergibt sich durch Kopplung des niederohmigen Sensorsignals (9) mit Hilfe eines Hochfrequenztransformators an einen LC-Resonanzkreises hoher Güte und Ausnutzung der Resonanzüberhöhung zur Verstärkung des Signals. Das mit einem Verstärker mit hoher Eingangsimpedanz (zur Vermeidung einer Belastung des Resonanzkreises) und aktivem Gleichrichter (AD8361) gleichgerichtete Sensorsignal ist in der Figur 11 als Funktion des Torsionswinkels gezeigt. Die schnellen Oszillationen wurden gemäß den obigen Ausführungen mittels einer optimal gewählten Flankensteilheit reduziert. Mit diesem einfachen Messaufbau ist eine sehr gute Empfindlichkeit des Sensors für die drei Größen Hᵤ, α, ΔL zu erzielen. Bei optimaler Anpassung von Pulsdauer, Frequenz und Flankensteilheit (die Anstiegsflanke und die Abfallsflanke des Stromimpulses haben unterschiedliche Einflüsse) erscheint am Resonanzkreis in guter Näherung eine Sinusschwingung, deren Amplitude und Phasenlage die charakteristischen Phasensymmetrien der direkten Signalimpulse bezüglich des Magnetfeldes und des Torsionswinkels widerspiegeln, d.h sowohl eine Umpolung des Magnetfeldes H (6) als Änderung des Vorzeichens der Torsion ändern das Vorzeichen des Sensorsignals. Das bei großem Torsionswinkel auftretende zweite Minimum (90) eines Sensors aus dem Material Vitrovac 6025F, der in seiner gesamten Länge, also von A bis D tordiert wurde, (Figur 11), zeichnet sich durch verschwindende Hysterese bei Torsionsänderungen aus, (was für viele Anwendungen erforderlich ist. Bei diesem Minimum findet ebenfalls eine Phasenumkehr des Sensorsignals statt.

Das hier vorgestellte Verfahren oder sinngemäße Teile dessen kann sowohl für die hier diskutierte Sensoranordnung WO 2007/051589 A2 als auch für andere Sensoren für Magnetfelder und mechanische Spannungen (Längenänderung und Torsion) auf der Basis der Magnetoelastizität bzw. der inversen Magnetoelastizität und einer magnetischen Anisotropiefeldstärke genutzt werden. Dazu gehören solche Sensoren, die auf dem "Giant Magneto Impedance"-Effekt und dem Procopiu-Effekt (auch Inverser Wiedemann Effekt genannt) beruhen. Beide Effekte werden auch an dem in WO 2007/051589 A2 beschriebenen Sensor beobachtet. So wurde gefunden, dass der zeitliche Verlauf der Spannungsimpulse an den Kontakten A,B als Antwort auf die Stromimpulse ebenfalls von Torsion, Magnetfeld und Zugspannung abhängt, allerdings in weniger ausgeprägter Form als das an C,D erscheinende Signal. Diese Abhängigkeit kann relativ einfach ergänzend zu der Auswertung der an C,D erscheinenden Signalimpulse benutzt werden, da das Signal ohnehin vorhanden ist. Auch ein induktives Signal in einer um das Segment C,D gewickelten Spule ist von den Größen Torsion, Magnetfeld und Zugspannung abhängig. Der Vorteil des hier diskutierten Verfahrens beruht jedoch gerade darauf, dass keine Spule zur Generierung des Signalimpulses benötigt wird und somit deren Nachteile wie konstruktive Komplikation und Einschränkung der zeitlichen Dynamik infolge der Induktivität der Spule entfallen.

## Patentansprüche

1. Verfahren zum Messen mindestens einer der Größen
- Torsionswinkel (30),
- Längenänderung (31),
- Magnetfeld (5),
mittels eines Sensors (3), in dem in einem ersten Leiterabschnitt (AB) einer magnetisierbaren oder magnetisierten elektrisch leitenden Leiteranordnung (AD) eine dynamische, insbesondere helikale Magnetisierung erzeugt wird,
- wobei eine Magnetisierung von dem ersten Leiterabschnitt (AB) in einen zweiten Leiterabschnitt (CD), der eine insbesondere helikale Anisotropie (α) aufweist, der Leiteranordnung (AD) transportiert wird,
- wobei die transportierte Magnetisierung mittels einer über dem zweiten Leiterabschnitt (CD) auf Grund des Transportes der Magnetisierung erzeugten Spannung (9) detektiert wird,
- wobei die detektierte Spannung (9) ein Maß für die Größe des Torsionswinkels (30), der Längenänderung (31), des Magnetfeldes (5) oder ein Mischmaß mehrerer dieser Größen ist,
- wobei zumindest ein Leiterabschnitt (AB) der Leiteranordnung, insbesondere die gesamte Leiteranordnung (AD) einem in seiner Magnetfeldstärke veränderten Magnetfeld (2) ausgesetzt wird,
- wobei die dynamische, insbesondere helikale Magnetisierung bei mindestens zwei unterschiedlichen Magnetfeldstärken des veränderbaren Magnetfelds (2) vorgenommen wird,
- wobei die mindestens zwei bei den unterschiedlichen Magnetfeldstärken erzeugten und detektierten Spannungen (9) zusammen zur Bildung des Maßes für die Größe des Torsionswinkels (30), der Längenänderung (31) und/oder des Magnetfeldes (5) verwendet werden.

2. Verfahren nach Anspruch 1, **dadurch gekennzeichnet, dass** die mindestens zwei unterschiedlichen Magnetfeldstärken des veränderbaren Magnetfelds (2) mit den zugehörigen dynamischen, insbesondere helikalen Magnetisierungen innerhalb eines vorbestimmten Zeitraums erzeugt werden.

3. Verfahren nach Anspruch 1 oder 2, **dadurch gekennzeichnet, dass** zur Bildung des Maßes für die Größe des Torsionswinkels (30), der Längenänderung (31) und/oder des Magnetfeldes (5) ein Kurvenverlauf (1) einer Vielzahl detektierter Spannungen in Abhängigkeit des veränderten Magnetfelds (2) verwendet wird.

4. Verfahren nach einem der vorhergehenden Ansprüche, **dadurch gekennzeichnet, dass** die dynamische, insbesondere helikale Magnetisierung in dem ersten Leiterabschnitt durch Überlagern zweier Magnetfelder erzeugt wird.

5. Verfahren nach einem der vorhergehenden Ansprüche, **dadurch gekennzeichnet, dass** das veränderbare Magnetfeld (2) längs zumindest zu dem Leiterabschnitt der Leiteranordnung erzeugt wird.

6. Verfahren nach einem der vorhergehenden Ansprüche, **dadurch gekennzeichnet, dass** die mindestens zwei unterschiedlichen Magnetfeldstärken des veränderbaren Magnetfelds (2) zwischen zwei vorbestimmten Grenzwerten (Hₘᵢₙ und Hₘₐₓ) erzeugt werden, die insbesondere unterschiedliche Vorzeichen haben.

7. Verfahren nach einem der vorhergehenden Ansprüche, **dadurch gekennzeichnet, dass** die dynamische, insbesondere helikale Magnetisierung durch einen an dem ersten Leiterabschnitt angelegten Spannungsimpuls erzeugt wird.

## Claims

1. Method for measuring at least one of the following variables
- torsion angle (30),
- length change (31),
- magnetic field (5)
using a sensor (3), in which dynamic, in particular helical, magnetization is produced in a first conductor section (AB) of a magnetizable or magnetized electrically conductive conductor arrangement (AD),
- magnetization being transported from the first conductor section (AB) into a second conductor section (CD), which has, in particular, helical anisotropy (α), of the conductor arrangement (AD),
- the transported magnetization being detected using a voltage (9) produced across the second conductor section (CD) on account of the transport of the magnetization,
- the detected voltage (9) being a measure of the variable of the torsion angle (30), the length change (31), the magnetic field (5) or a mixed measure of a plurality of these variables,
- at least one conductor section (AB) of the conductor arrangement, in particular the entire conductor arrangement (AD), being exposed to a magnetic field (2) whose magnetic field strength is changed,
- the dynamic, in particular helical, magnetization being carried out for at least two different magnetic field strengths of the changeable magnetic field (2),
- the at least two voltages (9) produced and detected at the different magnetic field strengths together being used to form the measure of the variable of the torsion angle (30), the length change (31) and/or the magnetic field (5).

2. Method according to Claim 1, **characterized in that** the at least two different magnetic field strengths of the changeable magnetic field (2) are produced with the associated dynamic, in particular helical, magnetizations within a predetermined period of time.

3. Method according to Claim 1 or 2, **characterized in that** a curve profile (1) of a multiplicity of detected voltages on the basis of the changed magnetic field (2) is used to form the measure of the variable of the torsion angle (30), the length change (31) and/or the magnetic field (5).

4. Method according to one of the preceding claims, **characterized in that** the dynamic, in particular helical, magnetization is produced in the first conductor section by superimposing two magnetic fields.

5. Method according to one of the preceding claims, **characterized in that** the changeable magnetic field (2) is produced longitudinally at least with respect to the conductor section of the conductor arrangement.

6. Method according to one of the preceding claims, **characterized in that** the at least two different magnetic field strengths of the changeable magnetic field (2) are produced between two predetermined limit values (Hₘᵢₙ and Hₘₐₓ) which have different signs, in particular.

7. Method according to one of the preceding claims, **characterized in that** the dynamic, in particular helical, magnetization is produced by means of a voltage pulse applied to the first conductor section.

## Revendications

1. Procédé de mesure d'au moins une des grandeurs suivantes :
- angle de torsion (30) ;
- variation de longueur (31) ;
- champ magnétique (5) ;
à l'aide d'un capteur (3), dans lequel dans une première section de conducteur (AB) d'un agencement conducteur (AD) électriquement conducteur magnétisable ou magnétisé, une magnétisation dynamique, notamment hélicoïdale, se produit :
- une magnétisation étant transportée de la première section de conducteur (AB) dans une deuxième section de conducteur (CD) comportant une anisotropie (α), notamment hélicoïdale, de l'agencement conducteur (AD) ;
- la magnétisation transportée étant détectée à l'aide d'une tension (9) produite par le biais de la deuxième section de conducteur (CD) sur la base du transport de la magnétisation ;
- la tension (9) détectée étant une mesure de la grandeur de l'angle de torsion (30), de la variation de longueur (31), du champ magnétique (5) ou une mesure mélangée de plusieurs de ces grandeurs ;
- au moins une section de conducteur (AB) de l'agencement conducteur, notamment la totalité de l'agencement conducteur (AD), étant exposée à un champ magnétique (2) variant dans sa puissance de champ magnétique ;
- la magnétisation dynamique, notamment hélicoïdale, étant effectuée pour au moins deux puissances de champ magnétique différentes du champ magnétique (2) variable :
- les au moins deux tensions (9) détectées et produites aux différentes puissances de champ magnétique étant utilisées conjointement pour la formation de la mesure de la grandeur de l'angle de torsion (30), de la variation de longueur (31) et/ou du champ magnétique (5).

2. Procédé selon la revendication 1, **caractérisé en ce que** les au moins deux puissances de champ magnétique différentes du champ magnétique (2) variable étant produites avec les magnétisations dynamiques, notamment hélicoïdales, associées pendant un intervalle de temps prédéfini.

3. Procédé selon la revendication 1 ou 2, **caractérisé en ce qu'**une courbe (1) d'une pluralité de tensions détectées est utilisée en fonction du champ magnétique (2) modifié pour former la mesure de la grandeur de l'angle de torsion (30), de la variation de longueur (31) et/ou du champ magnétique (5).

4. Procédé selon l'une quelconque des revendications précédentes, **caractérisé en ce que** la magnétisation dynamique, notamment hélicoïdale, est produite dans la première section de conducteur par superposition de deux champs magnétiques.

5. Procédé selon l'une quelconque des revendications précédentes, **caractérisé en ce que** le champ magnétique (2) variable est produit longitudinalement au moins par rapport à la section de conducteur de l'agencement conducteur.

6. Procédé selon l'une quelconque des revendications précédentes, **caractérisé en ce que** les au moins deux puissances de champ magnétique différentes du champ magnétique (2) variable se produisent entre deux valeurs limites prédéfinies (Hₘᵢₙ et Hₘₐₓ) présentant notamment des signes différents.

7. Procédé selon l'une quelconque des revendications précédentes, **caractérisé en ce que** la magnétisation dynamique, notamment hélicoïdale, est produite par une impulsion de tension appliquée à une première section de conducteur.
